(19) Europäisches Patentamt

European Patent Office

Office européen des brevets

(11) EP 1 434 348 A1

(12) **EUROPEAN PATENT APPLICATION**

(43) Date of publication:
30.06.2004  Bulletin 2004/27

(51) Int Cl.⁷: **H03K 5/24**, H03F 3/45, H04L 25/02

(21) Application number: 03290814.7

(22) Date of filing: 31.03.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **23.12.2002 EP 02293229**

(71) Applicant: **ALCATEL**
**75008 Paris (FR)**

(72) Inventor: **Gajdardziew Radelinow, Andrzej**
**2100 Deurne (BE)**

(74) Representative:
**Narmon, Gisèle Marie Thérèse et al**
**Alcatel Bell N.V.,**
**Francis Wellesplein 1**
**2018 Antwerpen (BE)**

(54) **Wideband common-mode regulation circuit**

(57)  A wideband common-mode regulation circuit for coupling a differential amplifier, or more particularly a Low Voltage Differential Signaling driver LVDS, to a load generally constituted by a telecommunication transmission line. The regulation circuit only comprises a first resistive pair (R1, R2) to sense the common-mode voltage at the differential input terminals (INP, INN), a second resistive pair (R3, R4) to force the voltage across the load to a predetermined value, and an active device (OTA, INV) coupled between the junction points of the first and the second resistive pairs. The active device is an Operational Transconductance Amplifier (OTA) or, preferably, an inverter (INV). Owing to reduced number of non-dominant poles in the common-mode open-loop transfer characteristic, this regulation circuit provides common-mode loop stability for wide common-mode loop bandwidth.

Fig. 2

EP 1 434 348 A1

**Description**

The present invention relates to a common-mode regulation circuit coupled to a load and comprising a common-mode sensing circuit adapted to sense a common-mode voltage and to provide a common-mode sensed signal, an active device responsive to said common-mode sensed signal and providing a common-mode correction signal, and a control circuit adapted to receive said common-mode correction signal and to force the voltage across said load to a predetermined voltage value.

Differential output stages and line drivers, e.g. for a telecommunication system, require a common-mode regulation circuit in order to keep the common-mode output voltage across their load at a pre-determined level and to reject common-mode variations as a consequence of differential signal amplification or processing.

A common-mode regulation circuit as mentioned above is already known in the art, e.g. from the Patent US 6,369,621. Therein, the common-mode regulation is realized with an operational amplifier as active device comparing the common-mode voltage of the driver, i.e. a common-mode sensed signal, with a predetermined reference voltage. This operational amplifier is regulating in a differential way the sink and source currents of the line driver in order to adjust the output common-mode voltage close to the reference value.

In this known common-mode regulation circuit, the number of parasitic poles in the common-mode open loop transfer characteristic limits the bandwidth of stable operation. Therefore the known circuit only serves as common-mode bias (DC and low-frequency regulation). Additionally, the differential operational amplifier requires own common-mode circuit. As a consequence, in case of wideband common-mode regulation, the known circuit cannot solve the problem in an efficient way.

The known circuit is further also relatively complex.

An object of the present invention is to provide a common-mode regulation circuit of the above known type but which is much simpler to implement while being adapted to operate in wideband applications.

According to the invention, this object is achieved due to the fact that said common-mode sensing circuit comprises a first pair of impedances series connected across said load and at the junction point of which said common-mode sensed signal is provided, and that said control circuit comprises a second pair of impedances series connected across said load and at the junction point of which said common-mode correction signal is applied.

In this way, a very simple circuit comprising only two pairs of impedances and an active device is realized. As a result, the number of parasitic poles is reduced and their frequencies can be an order of magnitude higher than in the prior art. High loop bandwidth can thereby be achieved. This also results in better suppression of common-mode variations with high frequency, which otherwise appear as unwanted noise and cause cross-talk when used in a telecommunication system.

Another characterizing embodiment of the present invention is that said active device is an Operational Transconductance Amplifier of which a first input is connected to the junction point of said first pair of series connected impedances, of which a second input is connected to a reference voltage terminal, and of which an output is connected to the junction point of said second pair of series connected impedances.

The invention makes use of a simple amplifying block as active device, while in the above-mentioned known circuit, there is a need for common-mode regulation and frequency compensation in the operational amplifier used. The amplifier is no longer controlling the sink/source current sources directly as in the above-mentioned document, but generates correction current which is added with opposite sign to the common-mode mismatch current in the load via the second pair of series connected impedances.

Preferably, the predetermined voltage value is the voltage available at said reference voltage terminal.

In a preferred characterizing embodiment of the invention, said active device is an inverter of which an input is connected to the junction point of said first pair of series connected impedances and of which an output is connected to the junction point of said second pair of series connected impedances.

In this preferred embodiment, a digital inverter is used instead of an operational amplifier as a gain block in the common-mode closed loop. It is thus even simpler to implement, as it doesn't require any reference voltage.

A further characterizing embodiment of the invention is that the predetermined voltage value is the threshold voltage of said inverter.

This implementation of the invention does not require a reference voltage because it is defined as the threshold voltage of the digital inverter used.

Moreover, the present wideband common-mode regulation circuit can drive any capacitive load without risk of common-mode oscillation because the open-loop dominant pole is created on the output terminals of the driver, while in the above-mentioned known circuit, the dominant pole is located in the operational amplifier. Therefore, the known circuit may oscillate if the output is capacitively loaded.

Further characterizing embodiments of the present common-mode regulation circuit are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:

Fig. 1 represents a first embodiment of a wideband common-mode regulation circuit including an Operational Transconductance Amplifier OTA according to the invention; and
Fig. 2 represents a second and preferred embodiment of a wideband common-mode regulation circuit including an inverter INV according to the invention.

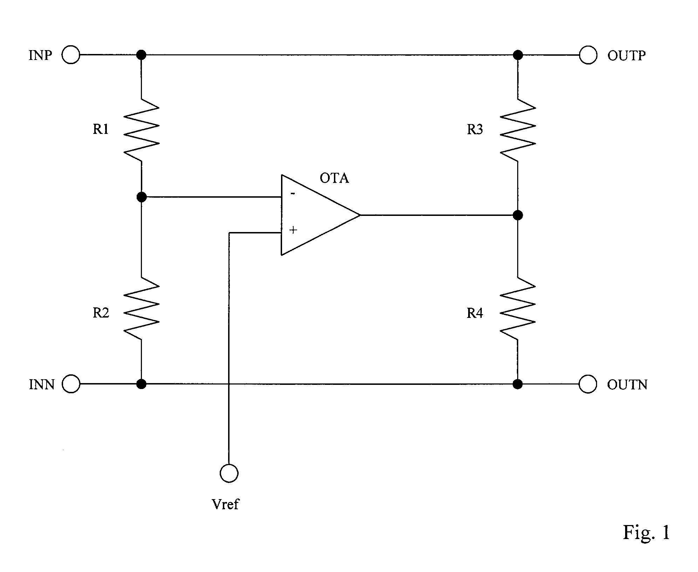

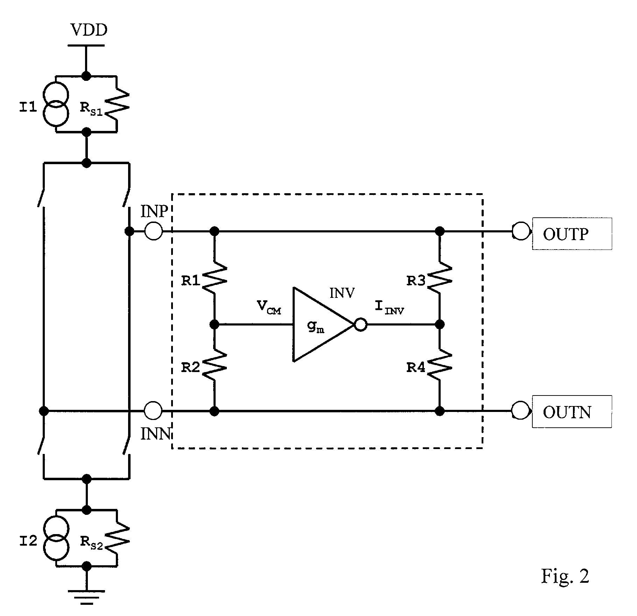

The wideband common-mode regulation circuit shown at Fig. 1 or its preferred embodiment shown at Fig. 2 is designed to be used, for instance, in a telecommunication system. The regulation circuit is generally located at the output of a differential amplifier or more particularly a Low Voltage Differential Signaling driver LVDS and its purpose is to compensate current mismatch between PMOS and NMOS current sources of the driver. The output of the regulation circuit is coupled to a load generally constituted by a differential transmission line. It has a high loop bandwidth that allows rejection of high-frequency variations of the common-mode voltage, generated by the LVDS driver or externally by the environment.

As shown at Fig. 1, the common-mode regulation circuit is adapted for biasing the output common-mode voltage of the driver at a voltage equal to a reference voltage Vref, usually equal to half the supply voltage. The common-mode loop is realized by two resistive pairs constituted by series connected resistors R1, R2 and R3, R4 respectively, and by an Operational Transconductance Amplifier OTA. The first resistive pair R1, R2 is used for sensing the common-mode voltage at the output of the driver, whilst the second resistive pair R3, R4 is used to force the driver output common-mode voltage to the reference voltage Vref by injecting common-mode current in the differential transmission line, generated by OTA and split by the resistors R3 and R4.

In more detail, the first R1, R2 and second R3, R4 resistive pairs are connected in parallel between the differential output terminals of the driver connected to input terminals INP and INN of the regulation circuit. The common-mode voltage Vcm across these terminals is equal to:

$$Vcm = \frac{V_{INP} + V_{INN}}{2}$$

where $V_{INP}$ and $V_{INN}$ are the respective voltages at the terminals INP and INN.

The junction point between the resistors R1 and R2 is connected to inverting input (-) of the amplifier OTA, of which the output is connected to the junction point of the resistors R3 and R4, the reference voltage VREF being applied to the non-inverting input (+) of OTA. The regulation circuit has output terminals OUTP and OUTN coupled to the telecommunication transmission line and connected across the second resistive pair R3, R4. The terminals INP, INN and OUTP, OUTN are thus respectively connected to each other while, as already mentioned, the output current capability of the Operational Transconductance Amplifier OTA compensates the current mismatch between PMOS and NMOS current sources in the LVDS driver.

In the preferred embodiment of the wideband common-mode regulation circuit shown at Fig. 2, the common-mode loop is also realized by two resistive pairs R1, R2 and R3, R4 but associated to an inverter INV. As for the previous embodiment, the two resistive pairs are connected across the interconnected terminals INP-OUTP and INN-OUTN. The first resistive pair R1, R2 is sensing the common-mode voltage that is further applied from the junction point of R1, R2 to an input of the inverter INV. The second resistive pair R3, R4 has its junction point connected to an output of the inverter INV and is used to force the driver output common-mode voltage to a reference voltage by injecting common-mode current in the differential transmission line coupled to the terminals OUTP and OUTN. This common-mode current is generated by the inverter INV and split by the resistive pair R3, R4. The so-formed closed loop network will regulate the common-mode output voltage of the driver to be close to the reference voltage that is the threshold voltage of the inverter INV. Hereafter, the voltage at the input of the inverter INV is called $V_{CM}$, whilst the current at the output of INV is called $I_{INV}$.

The Low Voltage Differential Signaling driver LVDS can be seen as the series coupling, between supply terminals VDD and ground, of:

- a first current source I1 in parallel with a first series resistor $R_{S1}$;
- two pairs of parallel connected and complementary operating switches; and
- a second current source I2 in parallel with a second series resistor $R_{S2}$.

It is to be noted that the ON resistance of the switches is neglected.

The junction points of the pairs of switches are connected to the input terminals INP and INN of the regulation circuit.

The total resistance of the resistive pairs R1, R2 and R3, R4 defines the output resistance of the driver which is matching the characteristic impedance of the transmission line connected to the line driver output.

The total common-mode resistance $R_{CM}$ of the line driver is:

$$R_{CM} = R_{S_1} \parallel R_{S_2}$$

A common-mode offset $V_{OFF\_CM}$ may be caused by mismatch between currents I1 and I2 of the like-named current sources, i.e. $I1 \neq I2$. In that case, the necessary compensation current $I_{INV}$ generated by the inverter INV is:

$$I_{INV} = \frac{V_{OFF\_CM}}{R_{CM}} - I_1 + I_2$$

With this common-mode offset, the compensation current $I_{INV}$ is generated by transconductance $g_m$ of the inverter INV:

$$g_m = \frac{I_{INV}}{V_{CM\_OFF}}$$

The advantage of this improved common-mode regulation is that it can provide loop stability for wide common-mode loop bandwidth, due to reduced number of non-dominant poles in the common-mode open-loop transfer characteristic.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

**Claims**

**1.** A common-mode regulation circuit coupled to a load (P, N) and comprising

a common-mode sensing circuit (R1, R2) adapted to sense a common-mode voltage and to provide a common-mode sensed signal,

an active device responsive to said common-mode sensed signal and providing a common-mode correction signal,

a control circuit (R3, R4) adapted to receive said common-mode correction signal and to force the voltage across said load to a predetermined voltage value,

*characterized in that* said common-mode sensing circuit comprises a first pair of impedances (R1, R2) series connected across said load (P, N) and at the junction point of which said common-mode sensed signal is provided,

*and in that* said control circuit comprises a second pair of impedances (R3, R4) series connected across said load and at the junction point of which said common-mode correction signal is applied.

**2.** The common-mode regulation circuit according to claim 1, *characterized in that* said active device is an Operational Transconductance Amplifier (OTA) of which a first input (-) is connected to the junction point of said first pair of series connected impedances (R1, R2), of which a second input (+) is connected to a reference voltage terminal (Vref), and of which an output is connected to the junction point of said second pair of series connected impedances (R3, R4).

**3.** The common-mode regulation circuit according to claim 2, *characterized in that* said predetermined voltage value is the voltage available at said reference voltage terminal (Vref).

**4.** The common-mode regulation circuit according to claim 1, *characterized in that* said active device is an inverter (INV) of which an input is connected to the junction point of said first pair of series connected impedances (R1, R2) and of which an output is connected to the junction point of said second pair of series connected impedances (R3, R4).

**5.** The common-mode regulation circuit according to claim 1, *characterized in that* said predetermined voltage value is the threshold voltage of said inverter (INV).

**6.** The common-mode regulation circuit according to claim 1, *characterized in that* said impedances are resistors.

**7.** The common-mode regulation circuit according to claim 1, *characterized in that* said load is a transmission line of a telecommunication system.

Fig. 1

EP 1 434 348 A1

Fig. 2

**European Patent Office**

**EUROPEAN SEARCH REPORT**

Application Number

EP 03 29 0814

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 6 369 621 B1 (CARVAJAL FERNANDO D ET AL) 9 April 2002 (2002-04-09) * figure 3 * | 1 | H03K5/24 H03F3/45 H04L25/02 |
| A | US 2002/190795 A1 (HOANG CHINH L) 19 December 2002 (2002-12-19) * the whole document * | 1 | |

TECHNICAL FIELDS SEARCHED (Int.Cl.7)

H03F
H04L

The present search report has been drawn up for all claims

| Place of search | Date of completion of the search | Examiner |
|---|---|---|
| MUNICH | 22 October 2003 | Brown, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 29 0814

This annex lists the patent family members relating to the patent documents cited in the above-mentioned European search report.
The members are as contained in the European Patent Office EDP file on
The European Patent Office is in no way liable for these particulars which are merely given for the purpose of information.

22-10-2003

| Patent document cited in search report | Publication date | Patent family member(s) | Publication date |
|---|---|---|---|
| US 6369621 B1 | 09-04-2002 | NONE | |
| US 2002190795 A1 | 19-12-2002 | WO 02103909 A1 | 27-12-2002 |

EPO FORM P0459

For more details about this annex : see Official Journal of the European Patent Office, No. 12/82